# EUROPÄISCHE PATENTSCHRIFT

(11) **EP 4 297 278 B1**
(45) Veröffentlichungstag und Bekanntmachung des Hinweises auf die Patenterteilung: **20.05.2026**
(21) Anmeldenummer: 23180956.7
(22) Anmeldetag: 22.06.2023
(51) Int. Cl.: H03K 17/92, H02M 1/00

(54) **HOCHTEMPERATUR SUPRALEITENDE SCHALTVORRICHTUNG**
HIGH TEMPERATURE SUPERCONDUCTING SWITCHING DEVICE
DISPOSITIF DE COMMUTATION SUPRACONDUCTEUR À HAUTE TEMPÉRATURE

(30) Priorität: 22.06.2022 LU 502329
(43) Veröffentlichungstag der Anmeldung: 27.12.2023
(73) Patentinhaber: Karlsruher Institut für Technologie, 76131 Karlsruhe (DE); Vision Electric Super Conductors GmbH, 67657 Kaiserslautern (DE)
(72) Erfinder: Noe, Dr. Mathias, Schauenberg (DE); Reiser, Dr. Wolfgang, Kaiserslautern (DE); Pham, Quoc Hung, Karlsruhe (DE); Martz, Simon, Karlsruhe (DE); Huwer, Stefan, Geiselberg (DE)
(74) Vertreter: Gille Hrabal Partnerschaftsgesellschaft mbB Patentanwälte

(56) Entgegenhaltungen:
- WO-A1-2017/021674
- WO-A1-2021/080443
- US-B2- 6 894 406
- GAWITH JAMIE ET AL: "HTS Transformer-Rectifier Flux Pump Optimization", IEEE TRANSACTIONS ON APPLIED SUPERCONDUCTIVITY, IEEE, USA, vol. 29, no. 5, 1 August 2019 (2019-08-01), pages 1 - 5, XP011721827, ISSN: 1051-8223, [retrieved on 20190425], DOI: 10.1109/TASC.2019.2904444
- BYKOVSKIY NIKOLAY ET AL: "Thermally Activated ReBCO Switches for Charging High-Current Magnets", IEEE TRANSACTIONS ON APPLIED SUPERCONDUCTIVITY, IEEE, USA, vol. 29, no. 5, 1 August 2019 (2019-08-01), pages 1 - 5, XP011732299, ISSN: 1051-8223, [retrieved on 20190626], DOI: 10.1109/TASC.2019.2895849

## Beschreibung

Die Erfindung betrifft eine hochtemperatur supraleitende Schaltvorrichtung.

Hochtemperatur supraleitende Leiter, nachfolgend "HTSL" oder "HTSC" (engl.), werden beispielsweise für Hochstromzwecke eingesetzt, bei denen Gleichstrom oder Wechselstrom im Bereich von Kiloampere bis zu Megaampere übertragen werden soll und dessen Leitermaterial im Wesentlichen aus Hochtemperatursupraleitern besteht, die im Nenntemperaturbereich unterhalb der sogenannten Sprungtemperatur den Gleichstrom verlustfrei leiten können. Diese HTSL liegen häufig nicht in der klassischen Drahtform vor, sondern als Bandmaterial in üblichen Breiten von 4, 10, 12mm und geplant bis zu 100mm, sowie in Dicken von 20 bis 300µm vor. Sie werden zur Erreichung der erforderlichen hohen Stromtragfähigkeit des Systemelements zu Stapeln zusammengefasst. Ein oder mehrere Stapel ergeben einen Strang. Ein oder mehrere Stränge ergeben die Stromtragfähigkeit des Gesamtsystems. Im Folgenden wird die Erfindung beispielartig anhand von den handelsüblichen Hochtemperatursupraleiterbändern (HTSL -Bänder) beschrieben, die mit allen hier genannten Merkmalen Bestandteil der Erfindung sein können. HTSL Bänder bestehen im Wesentlichen aus einer auf einem metallischen Träger oder Substrat aufgebauten, dünnen keramischen Schicht, die bei Unterschreitung der sogenannten Sprungtemperatur supraleitend wird. Die Schichten eines HTSL setzen sich je nach Anforderung, Hersteller oder Herstellverfahren unterschiedlich zusammen. In der Regel ist die supraleitende Schicht mit einer dünnen Silberschicht von 0,5 - 2µm beaufschlagt. Das fertige HTSL-Band kann zusätzlich noch galvanisch oder durch Laminieren mit einer Stabilisierung aus Kupfer beschichtet sein. Weiterhin kann der Leiter galvanisch oder durch Tauchen im Bad mit Lot beschichtet sein.

Werden die HTSL-Bänder in Stapeln geschichtet, so beeinflussen sie sich gegenseitig über das selbst erzeugte Magnetfeld, in der Form, dass sich die Stromtragfähigkeit jedes einzelnen HTSL-Bandes umso mehr reduziert je höher das Magnetfeld, dem es an seiner Stapelposition ausgesetzt ist. Es ist bekannt, dass Supraleiter hochohmig gemacht werden können durch Strom, Magnetfeld und/oder Temperatur, was beispielsweise eingesetzt wird in Strombegrenzern durch Strom zur Begrenzung von Kurzschlussströmen und in Flusspumpen durch Magnetfelder zur Ladung von supraleitenden Magneten. Für die Übertragung von hohen bis sehr hohen Strömen im Kiloampere- bis hin zum Megaamperebereich ist es für die Anwendungen der Hochtemperatursupraleitung aufgrund der Gleichung zur Verlustleistung PV = I² x R notwendig an den Verbindungstellen der Supraleiter einen sehr kleinen elektrischen Kontaktwiderstand zu haben.

Die HTSL-Stapel bzw. -Stränge, die den Strom durch das supraleitende Stromschienensystem leiten, bestehen aus einer Vielzahl von einzelnen HTSL-Bändern, etwa um Zwanzig bis mehrere Hundert, je nach Temperatur und der erforderlichen zu übertragenden Stromstärke.

WO 2021/080443 A1 offenbart einen supraleitenden Schalter, der eine geschlossene Schleife aus zwei parallelen supraleitenden Zweigen aufweist. Zum Schalten wird ein zeitlich veränderliches Magnetfeld verwendet, um einen Abschirmstrom ("screening current") in der Schleife zu induzieren. Der hochohmige Zustand wird dadurch erreicht, dass die Summe aus dem Transportstrom und dem induzierten Abschirmstrom den kritischen Strom (Ic) des supraleitenden Materials erreicht oder überschreitet.

GAWITH JAMIE ET AL: "HTS Transformer-Rectifier Flux Pump Optimization" und WO 2017/021674 A1 beschreiben das grundlegende physikalische Prinzip von sogenannten "AC field switches" oder "dynamic resistance switches". Bei diesen wird ein Widerstand durch die Wechselwirkung eines Gleichstrom-Transportstroms mit einem angelegten AC-Magnetfeld erzeugt. Es wird dargelegt, dass die Stärke des AC-Magnetfeldes dabei deutlich geringer sein kann als das kritische statische Magnetfeld (Bc), das zur Unterdrückung der Supraleitung erforderlich wäre.

US 6,894,406 B2 offenbart ein supraleitendes Schaltelement, das durch die Bestrahlung mit hochfrequenter elektromagnetischer Energie geschaltet wird. Der hierbei genutzte Mechanismus besteht darin, den Hochtemperatursupraleiter gezielt aus dem supraleitenden in den normalleitenden Zustand zu überführen.

Es ist daher Aufgabe der Erfindung eine verbesserte hochtemperatur-supraleitende Schaltvorrichtung bereitzustellen.

Diese Aufgabe wird erfüllt durch eine hochtemperatur-supraleitende Schaltvorrichtung mit den Merkmalen des Hauptanspruchs. Vorteilhafte Ausgestaltungen sind Gegenstand der Unteransprüche.

Die erfindungsgemäße hochtemperatur-supraleitende Schaltvorrichtung verfügt zunächst über eine Stromverbindung, welche sich aber zu mindestens zwei unabhängig voneinander schaltbaren alternativen Strompfaden verzweigt. Die Stromverbindung und die Strompfade weisen durchgängig HTSL auf, so dass der Strom auf seinem Weg keinerlei Normalleiter durchfließen muss. Die HTSL sind dabei ausgelegt zum Leiten eines Transportstroms, was der Fachmann errechnen kann. Ferner ist eine Kühlvorrichtung zum Kühlen der HTSL unterhalb von deren Sprungtemperatur vorgesehen.

Üblicherweise umfasst die Kühlvorrichtung zum Kühlen des Hochtemperatursupraleiters unterhalb von deren Sprungtemperatur, ein flüssiges Kühlmedium, wobei der Hochtemperatursupraleiter in das Kühlmedium getaucht ist. Das Kühlmittel umströmt dabei in der Regel den Supraleiter.

Das Schalten der schaltbaren alternativen Strompfade erfolgt über schaltbare Magnete. Dabei wird der bekannte Effekt ausgenutzt, dass Supraleiter hochohmig gemacht werden können durch Magnetfelder. Dazu sind jedem Strompfad jeweils ein schaltbarer Magnet räumlich zugeordnet und die Magnete sind mit einer Steuerung verbunden. Zum Schalten der Magnete kann jede technisch zweckmäßige Lösung eingesetzt werden, z.B. auch mechanisch bewegte Magnete. Erfindungsgemäß bevorzugt sind aber Elektromagnete mit einer entsprechenden elektrischen Ansteuerung mit einer Wechselstromquelle, so dass ein Wechselstrom durch die Elektromagnete fließen kann. Der Vorteil liegt darin, dass Magnetfelder sehr schnell, flexibel, mit frei wählbarer Frequenz und Magnetfeldstärke erzeugt werden können.

Ferner ist wesentlich, dass jeder schaltbare Magnet ausschließlich auf den ihm zugeordneten Strompfad mit seinem Magnetfeld wirken kann. Der Fachmann kann die notwendige Auslegung, Abstände, Abschirmungen, Magnetfeldstärken und Wechsel-Magnetfeldfrequenzen ermitteln. Im Ergebnis ist
- jeder schaltbare Magnet so zu dem ihm zugeordneten Strompfad angeordnet und kann durch die Steuerung so angesteuert werden, dass er durch Erzeugen eines Wechsel-Magnetfeldes im HTSL des zugeordneten Strompfads **einen** dynamischen Widerstand erzeugen kann, der den Strompfad hochohmig macht, wobei gleichzeitig
- jeder schaltbare Magnet so zu dem ihm nicht zugeordneten Strompfad angeordnet ist und durch die Steuerung so angesteuert werden kann, dass er durch Erzeugen eines Wechsel-Magnetfeldes im HTSL des **nicht** zugeordneten Strompfads **keinen** dynamischen Widerstand erzeugen kann, so dass der nicht-zugeordnete Strompfad supraleitend bleibt.

Dabei wird der folgende, sonst unerwünschte Effekt genutzt, um Magnetspulen und zu ihrem Betrieb benötigte Ströme erheblich zu reduzieren: Der durch ein Wechsel-Magnetfeld (AC magnetic field) erzeugte dynamische Widerstand beeinträchtigt die Gleichstrom-Stromtragfähigkeit eines Supraleiters. Bei der Verwendung von Supraleitern in Anwendungen wie Stromkabel, Transformatoren und Motoren, fließt ein Gleichstrom-Transportstrom in einem Supraleiter in einem externen magnetischen Wechselfeld. In diesem Fall wird im Supraleiter in unerwünschter Weise aufgrund von Transport- und Magnetisierungsverlusten Leistung abgeführt, was als "dynamischer Widerstand" bezeichnet wird. Dieser dynamische Widerstand lässt sich abschätzen, z.B. Dynamic resistance in a slab-like superconductor with Jc(B) dependence; M P Oomen et al. 1999 Supercond. Sci. Technol. 12 382.

Bei statischen Magnetfeldern dagegen, werden zur Berechnung der Stromtragfähigkeit üblicherweise die folgenden drei physikalischen Größen herangezogen, welche eine entscheidende Auswirkung auf die Anwendung der Supraleitung haben: Die kritische Temperatur Tc, die kritische Stromdichte jc und das kritische äußere Magnetfeld Hc. In einem XYZ-Koordinatensystem mit den genannten drei Größen als Achsen, ergibt sich eine Raumkurve als Grenze des supraleitenden Zustandes. Innerhalb der Raumkurve besteht der supraleitende Zustand und außerhalb der normalleitende Zustand. Die Raumkuve definiert dabei den Zusammenhang zwischen den kritischen Werten Tc, jc und Hc. Dabei bezieht sich das kritische äußere Magnetfeld Hc auf ein ein statisches äußeres Magnetfeld.

Durch den Einsatz eines Wechsel-Magnetfeldes zur Erzeugung des dynamischen Widerstandes wird der betroffene Supraleiter mit zum Teil um einigen Größenordnungen geringeren magnetischen Feldstärken hochohmig gemacht, als bei statischen Magnetfedern. Die kritische statische magnetische Feldstärke ist größer als die kritische Feldstärke des Wechsel-Magnetfeldes, meist um ein Vielfaches und in vielen Fällen um einige Größenordnungen. Der Fachmann kann für den Einsatzzweck eine Auslegung in Bezug auf Feldstärke und Frequenz vornehmen.

Mit anderen Worten: Der dynamischer Widerstand bedeutet, dass der Supraleiter von einem Magnetfeld, das an sich als statisches Feld zu schwach ist, um die Stromtragfähigkeit des Supraleiters nicht maßgeblich herabzusetzen, allein durch die Anwendung der Frequenz den Supraleiter in einen Widerstand treibt.

Vorteilhafte Frequenzen des Wechsel-Magnetfeldes liegen im Bereich 40 - 4.000 Hz, vorzugsweise 200 - 2.000 Hz und insbesondere vorzugsweise 400 - 1.200 Hz.

Erfindungsgemäß wird eine neue Art von Wechselschalter bereitgestellt, der ohne verschleißträchtige und langsame mechanische Trenner (z.B. Schaltkontakte) oder leistungsverlustbehaftete elektronische Leistungshalbleitern (Dioden, Transistoren, Tyrostoren) arbeitet. Die wesentlichen Vorteile gegenüber diesem Stand der Technik liegt daher in den sehr geringen Durchlassverlusten, da die Durchlassspannungen bei Hochtemperatur-Supraleitern nahezu vernachlässigbar sind gegenüber Leistungshalbleitern. Ferner liegt eine sehr gute Hochskalierbarkeit auf höhere Ströme vor, wegen der hohen Stromtragfähigkeit von Hochtemperatur-Supraleitern. Ebenso kann die Schaltung auf hohe Spannungen skaliert werden.

Abgesehen davon, dass Supraleiter bei gleicher Stromtragfähigkeit ohnehin dramatisch weniger Raum beanspruchen, können die erfindungsgemäß supraleitenden Schaltelemente, deren HTSL z.B. unter flüssigen Stickstoff liegen, sehr viel kleiner ausgeführt werden, da gerade bei hohen Spannungen die Isolationsabstände im flüssigen Stickstoff deutlich geringer sind.

Vorzugsweise ist beim Kommutierungsvorgang vorgesehen, dass die Steuerung die schaltbaren Magnete so ansteuert, dass wenn der eine Strompfad supraleitend ist und der andere Strompfad hochohmig ist und ein Schaltvorgang stattfinden soll, bei welchem der eine Strompfad hochohmig wird ist und der andere Strompfad supraleitend wird, die Steuerung für eine definierte Zeit im Schaltvorgang beide Strompfade supraleitend hält. Es sollen also beim Umschalten von einem Strompfad auf den anderen Strompfad für eine bestimmte Zeit beide Strompfade supraleitend sein. Durch das genaue Einstellen dieser Umschaltzeiten können auftretende Schaltverluste minimiert werden, so dass höhere Wirkungsgrade beim Betrieb der erfindungsgemäßen Schaltvorrichtungen erreicht werden.

Bei allen Hochtemperatursupraleitern handelt es sich um keramische Materialien, die sehr spröde sind. Diese können wie folgt zu Draht verarbeitet werden: Die "erste Drahtgeneration" wird nach dem Powder-in Tube-Verfahren hergestellt. Das Supraleitermaterial wird als Pulver in ein Silberrohr gefüllt, das anschließend so bearbeitet wird, dass sehr dünne Drähte entstehen, die zu Filamenten zusammengefasst werden. Da dieser Draht zu 70% aus Silber besteht, ist er entsprechend teuer. Die "zweite Drahtgeneration" besteht aus beschichteten Bandleitern, den sogenannten Coated Conductors. Je nach Beschichtungsverfahren variiert die Leistungsfähigkeit der Bandleiter. Es ist zu erwarten, dass der Preis für Supraleiter unter das Niveau konventioneller Kupferleiter sinken wird. Zum Beispiel wurden Bänder mit supraleitender Beschichtung auf YBCO-Basis entwickelt, wobei nicht nur die Sprödigkeit der keramischen Leitersubstanz überwunden wurde. Ferner sind in der Beschichtung alle Kristalle des Leitermaterials gleichförmig auszurichten, da der Ladungstransport in Hochtemperatursupraleitern stark richtungsabhängig ist und fast ausschließlich in bestimmten Schichten ihrer Kristallstruktur erfolgt.

Vorzugsweise sind die HTSL durch HTSL Bänder der sogenannten zweiten Generation der HTSL Bandleiter auf der Basis von ReBCO Material gebildet. Re steht für Rare Earth und je nach Hersteller werden hier verschiedene Materialen wie Yttrium oder Gadolinium verwendet. Beispielsweise können Yttrium-Barium-Kupferoxid und Bismut-Strontium-Calcium-Kupferoxid Substanzen mit ihren Sprungtemperaturen von 93 K bzw. 110 K problemlos mit Flüssigstickstoff unter ihre Sprungtemperatur gekühlt werden.

Zweckmäßigerweise ist darauf zu achten, dass die Stromverbindung den gleichen stromführenden Querschnitt aus HTSL hat, wie die alternativen Strompfade zusammen. Dabei hat vorzugsweise jeder der alternativen Strompfade den gleichen stromführenden Querschnitt aus HTSL. Dies widerspricht der üblichen Auslegungsregel, dass der Querschnitt der Stromverbindung nicht größer sein muss, als der Querschnitt von jedem einzelnen alternativen Strompfad. Bei dieser Auslegung ergibt sich aber die Möglichkeit, einen fertigungstechnischen Vorteil zu nutzen, bei dem keine aufwendige und widerstandsbehaftete Kontaktierung der Stromzuführung mit den alternativen Strompfaden nötig ist:
Dabei sind erfindungsgemäß die Stromverbindung und alle alternativen Strompfade einstückig aus HTSL, vorzugsweise HTSL Bändern, bestehen, sodass diese keine Fügezonen mit Übergangswiderstand aufweisen. Anstelle eines Verbindens der Zuführung mit den Pfaden, wird die Zuführung einfach verzweigt, z.B. durch aufschneiden entlang der Längsachse:
Dazu sind die HTSL-Bänder im Bereich nur außerhalb der Stromverbindung und/oder zumindest im Wirkungsbereich der dem jeweiligen Strompfad zugeordneten schaltbaren Magnete senkrecht zur ihrer Bandebene entlang ihrer Längsachse geschnitten / aufgetrennt zur Ausbildung von den alternativen Strompfaden. Das Auftrennen / Schneiden ersetzt also ein aufwendiges widerstandsbehaftetes Zusammenfügen von Stromverbindung und alternativen Strompfaden. Durch diese geschickte Auslegung werden Verbindungsstellen vermieden.

Bisher ist das sogenannte "Schalten im Kalten" nicht realisiert. Darunter wird verstanden, dass ein Schalten der Supraleiter mittels einer Schaltvorrichtung erfolgt, wobei das Schaltelement ebenfalls in einem unterhalb der Sprungtemperatur gekühlten flüssigen Gas, z.B. N, He, H, Ne getaucht ist. Beim Öffnen des Kontakts kann ein Lichtbogen auftreten, welcher lokal durch Wärmezufuhr einen Phasenübergang von flüssig zu gasförmig bewirkt, wobei eine unerwünschte Volumenexpansion des flüssigen Gases stattfindet, typischerweise um den Faktor 700. Dies ist erfindungsgemäß ausgeschlossen.

Wie oben erläutert, kann die erfindungsgemäße Schaltvorrichtung als verlustloser Leistungsschalter zum Umschalten eines Stromes von einem Strompfad auf einen anderen genutzt werden. Ferner wird vorgeschlagen, diese Schaltelemente als wesentlichen Bestandteil vorzusehen von verlustleistungsarm arbeitenden **Umrichter-, Gleichrichter- oder Wechselrichter-Schaltungen.**

Auf dem technischen Gebiet der Energietechnik sind Umrichter-, Gleichrichter- oder Wechselrichter-Schaltungen verbreitet. Ein Umrichter, auch als Wechselstrom-Umrichter oder AC/AC-Konverter bezeichnet, ist ein Stromrichter, der aus einer Wechselspannung eine in Frequenz und Amplitude verschiedene neue Wechselspannung generiert. Gleichrichter werden zur Umwandlung von Wechselspannung in Gleichspannung verwendet. Ein Wechselrichter, Inverter oder Drehrichter ist ein elektrisches Gerät, das Gleichspannung in Wechselspannung umwandelt. Die oben genannten Richter fallen unter den Oberbegriff Stromrichter, also elektrische Geräte bzw. Anlagen ohne bewegliche Teile zur Umwandlung einer eingespeisten elektrischen Stromart (Gleichstrom, Wechselstrom) in die jeweils andere, oder zur Änderung charakteristischer Parameter wie der Spannung und der Frequenz.

Alle Stromrichter sowie Stromschalter umfassen leistungselektronische Bauelemente. Dies ist mit hohen Durchlass- und Schaltverlusten verbunden sowie mit einem hohen Aufwand für die Isolation bei Hochspannung und den entsprechenden Abmessungen. Halbleiter, beispielsweise Dioden, IGBT, etc., finden Anwendung in Umrichter- und Gleichrichterschaltungen. Halbleiterbauelemente besitzen hohe Durchlassverluste und sind in der Regel für maximale Spannungen pro Bauelement ausgelegt.

Der erfindungsgemäße **Gleichrichter** mit der oben beschriebenen Schaltvorrichtung ist so ausgestaltet, dass bei Anschluss der Stromzuführung an eine Wechselspannung die Steuerung
- den einen Strompfad nur solange ansteuert und somit hochohmig macht, wie die Wechselspannung positive Spannungen durchläuft; und
- den andere Strompfad nur solange ansteuert und somit hochohmig macht, wie die Wechselspannung negative Spannungen durchläuft.

Sinngemäß ist also der eine Strompfad nur während der positiven Halbwelle supraleitend, während der andere Strompfad nur während der negativen Halbwelle supraleitend ist. Der eine Strompfad bildet daher den (nicht geglätteten) Pluspol und der andere den Minuspol.

Es wurde bereits beschrieben, dass beim Umschaltvorgang vermieden werden muss, dass für einen kurzen Moment alle Strompfade hochohmig sind die Spannungsspitzen beim Abschalten von induktiven Lasten einen zu hohen Stromfluss in den hochohmigen gewordenen Strompfaden erzeugen, welche dadurch unnötig erhitzt werden. Daher ist vorzugsweise vorgesehen, dass die Steuerung im Zeitraum eines Nulldurchgangs der Wechselspannung beide Strompfade kurzzeitig nicht ansteuert und somit supraleitend hält. Dieser Zeitraum des Nulldurchgangs kann vom Fachmann an die Auslegung des Gleichrichters angepasst werden. Als vorteilhaft hat sich erwiesen:
- eine Zeit von 1/1.000 der Periode des Wechselstroms vor und nach dem Nulldurchgang; oder
- eine Zeit während der der Absolutwert der Wechselspannung kleiner als 0,6% der Dachspannung des Wechselstroms ist.

Analog zum Gleichrichter, ist der erfindungsgemäße **Wechselrichter** mit der oben beschriebenen Schaltvorrichtung so ausgestaltet, dass bei Anschluss der Stromzuführung an eine Gleichspannung die Steuerung wechselweise mit einer Frequenz den einen Strompfad oder den anderen Strompfad ansteuert und hochohmig macht. Dieser Umschaltvorgang erfolgt dabei mit der gewünschten Wechselstromfrequenz.

Die erfindungsgemäße Schaltvorrichtung kann ferner eingesetzt werden als Modulationsvorrichtung oder Pulsweitenmodulationsvorrichtung.

Die oben beschriebenen Gleichrichter bzw. Wechselrichter wurden bisher beschrieben unter Nutzung von nur einer einzigen Schaltvorrichtung, und somit nur mit einer Stromverbindung, die nur einem Eingangspol entspricht. Ausgangsseitig, d.h. an den freien Enden der alternativen Strompfade liegt dagegen ein mehrpoliger Ausgang vor. Zweckmäßigerweise hat aber der Gleichrichter bzw. Wechselrichter vorzugsweise nicht nur eine, sondern zwei Stromverbindungen und somit zwei Eingangspole für das Anlegen einer Wechsel- bzw. Gleichspannung. Vereinfacht gesagt, werden dabei zwei gleichartige gleichsinnig angesteuerte erfindungsgemäße Schaltvorrichtungen mit paarweise gekreuzten verbundenen alternativen Strompfaden vorgesehen, die somit zwei Stromverbindungen bzw. Eingangspole bereitstellen: Die freien Enden der alternativen Strompfade beider Schaltvorrichtungen sind über Kreuz miteinander verbunden, d.h. der erste Strompfad der ersten Schaltvorrichtung ist ausgangsseitig mit dem zweiten Strompfad der zweiten Schaltvorrichtung verbunden und analog ist der zweite Strompfad der ersten Schaltvorrichtung ausgangsseitig mit dem ersten Strompfad der zweiten Schaltvorrichtung verbunden. Die freien Enden der derart paarweise zusammengeführten alternativen Strompfade bilden somit die beiden Ausgangspole des Gleichrichters bzw. Wechselrichters. Ferner werden über die Steuerung beide Schaltvorrichtungen gleichsinnig betrieben, d.h. die den Strompfaden zugeordneten schaltbaren Magnete schalten synchron die beiden ersten alternativen Strompfade bzw. die beiden zweiten alternativen Strompfade.

Vorzugsweise weist der Gleichrichter bzw. Wechselrichter daher eine zweite erfindungsgemäße Schaltvorrichtung auf, wobei die Stromverbindung der ersten Schaltvorrichtung und die Stromverbindung der zweiten Schaltvorrichtung zwei Eingangspole des Gleichrichters bzw. Wechselrichters bilden. Ferner sind die zwei unabhängig voneinander schaltbaren alternativen Strompfade der ersten Schaltvorrichtung und die zwei unabhängig voneinander schaltbaren alternativen Strompfade der zweiten Schaltvorrichtung über Kreuz miteinander supraleitend verbunden zur Bildung von zwei Ausgangspolen des Gleichrichters bzw. Wechselrichters. Dabei sind die ersten Magnete (MA,MB) der ersten Schaltvorrichtung und die zweiten Magnete (MA1,MB1) der zweiten Schaltvorrichtung mit einer gemeinsamen Steuerung (S) verbunden sind und werden von dieser gleichsinnig angesteuert.

Erfindungsgemäß wird sogar ein Stromrichter offenbart, der gleichermaßen als Gleich- und Wechselrichter betreibbar ist, nur in Abhängigkeit von der Ansteuerung der schaltbaren Magnete.

Vorzugsweise können die gleichsinnig angesteuerten Magnete (MA, MA1 bzw. MB, MB1) jeweils als ein gemeinsamer Magnet ausgebildet sein, wobei
jeder gemeinsame Magnet so zu den ihm zugeordneten Strompfaden (A, A1 bzw. B, B1) angeordnet ist und durch die Steuerung so angesteuert werden kann, dass er durch Erzeugen eines Wechsel-Magnetfeldes im HTSL der zugeordneten Strompfade (A, A1 bzw. B, B1) einen dynamischen Widerstand erzeugen kann, der die Strompfade hochohmig macht, wobei
jeder gemeinsame Magnet so zu den ihm nicht zugeordneten Strompfaden (A, A1 bzw. B, B1) angeordnet ist und durch die Steuerung so angesteuert werden kann, dass er durch Erzeugen eines Wechsel-Magnetfeldes im HTSL der nicht zugeordneten Strompfade (A, A1 bzw. B, B1) keinen dynamischen Widerstand erzeugen kann, so dass der nicht-zugeordnete Strompfad supraleitend bleibt.

Schließlich ist auf Basis der erfindungsgemäßen Schaltvorrichtung einfach ein Umrichter realisierbar, indem die Ausgangspole, also die freien Enden der alternativen Strompfade des erfindungsgemäßen Gleichrichters mit den Stromverbindungen eines dahinter geschalteten erfindungsgemäßen Wechselrichters leitend verbunden sind.

Das erfindungsgemäße Konzept kann auch auf mehrphasige Systeme, z.B. 3-Phasen-Wechselstrom, auf für den Fachmann nahegelegte Weise übertragen werden.

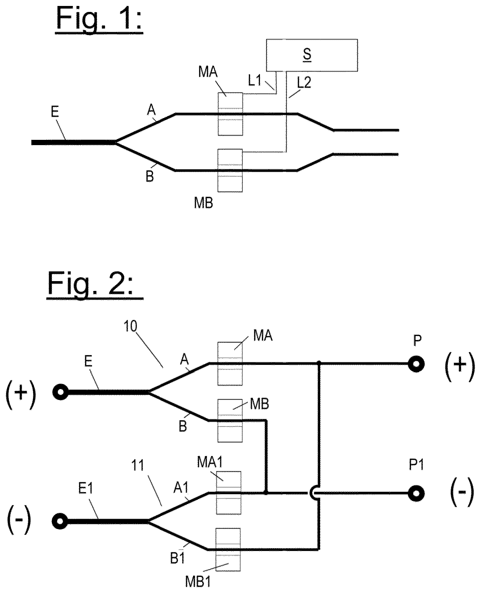

**Fig. 1** zeigt die Grundform der hochtemperatur-supraleitenden Schaltvorrichtung, mit einer eingangsseitigen Stromverbindung E. Die verzweigt sich zu mindestens zwei unabhängig voneinander schaltbaren alternativen Strompfaden A, B. Die Stromverbindung E und die Strompfade A,B sind durchgängig als HTSL ausgeführt und sind ausgelegt zum Leiten eines Transportstroms von der Stromverbindung E bis zu den freien Enden der alternativen Strompfaden A, B. Nicht dargestellt ist, dass die Stromverbindung E bis zu den freien Enden der alternativen Strompfade A, B mittels einer Kühlvorrichtung zum Kühlen der HTSL unterhalb von deren Sprungtemperatur gehalten wird.

Ferner ist jedem Strompfad A,B ein schaltbarer Magnet MA, MB räumlich zugeordnet ist. Diese Magnete MA, MB sind mit einer Steuerung S verbunden, damit einzelne Strompfade A,B gezielt hochohmig gemacht werden können:
Der schaltbare Magnet MA ist so zu dem ihm zugeordneten Strompfad A angeordnet und durch die Steuerung S so angesteuert, dass er durch Erzeugen eines Wechsel-Magnetfeldes im HTSL des zugeordneten Strompfads A einen dynamischen Widerstand erzeugen kann, der den Strompfad hochohmig macht. Um eine unbeabsichtigte unerwünschte Beeinflussung des dem Magneten MA nicht zugeordneten Strompfades B zu vermeiden, ist dabei jeder schaltbare Magnet MA so zu dem ihm nicht zugeordneten Strompfad B angeordnet und durch die Steuerung so angesteuert, dass er durch Erzeugen eines Wechsel-Magnetfeldes im HTSL des nicht zugeordneten Strompfads B keinen dynamischen Widerstand erzeugen kann, so dass der nicht-zugeordnete Strompfad supraleitend bleibt.

Beim Kommutierungsvorgang ist darauf zu achten, dass die Steuerung S die schaltbaren Magnete MA, MB so ansteuert, dass wenn der eine Strompfad A supraleitend ist und der andere Strompfad B hochohmig ist und ein Schaltvorgang stattfinden soll, bei welchem der eine Strompfad A hochohmig wird ist und der andere Strompfad supraleitend B wird, die Steuerung für eine definierte Zeit im Schaltvorgang beide Strompfade A,B supraleitend hält.

Die Grundform aus Fig. 1 verfügt nur über eine Stromverbindung E und ist daher einpolig.

**Fig. 2** zeigt die zweipolige Anordnung von zwei Schaltvorrichtungen aus Fig. 1: Dabei werden zwei gleichartige gleichsinnig angesteuerte erfindungsgemäße Schaltvorrichtungen 10,11 mit paarweise gekreuzten verbundenen alternativen Strompfaden A,B,A1,B1 vorgesehen, die somit zwei Stromverbindungen E, E1 bzw. Eingangspole bereitstellen: Die freien Enden der alternativen Strompfade A,B,A1,B1 beider Schaltvorrichtungen 10,11 sind über Kreuz miteinander verbunden, d.h. der erste Strompfad A der ersten Schaltvorrichtung 10 ist ausgangsseitig mit dem zweiten Strompfad B1 der zweiten Schaltvorrichtung 11 verbunden und analog ist der zweite Strompfad B der ersten Schaltvorrichtung 10 ausgangsseitig mit dem ersten Strompfad A1 der zweiten Schaltvorrichtung 11 verbunden. Die freien Enden der derart paarweise zusammengeführten alternativen Strompfade A,B,A1,B1 bilden somit die beiden Ausgangspole P,P1 des Gleichrichter bzw. Wechselrichters. Ferner werden über die Steuerung beide Schaltvorrichtungen gleichsinnig betrieben, dh die den Strompfaden A,B bzw. A1,B1 zugeordneten schaltbaren Magnete (MA,MB bzw. MA1,MB1) schalten synchron die beiden ersten alternativen Strompfade A,A1 bzw. die beiden zweiten alternativen Strompfade B,B1. Das zum Kommutierungsvorgang beschriebene gilt auch hier.

Abweichend von Fig. 2 ist bevorzugt, dass jeder einzelne Weg vom Stromeingang E, bzw. E1 zum Ausgangspol P bzw. P1 durchgängig unterbrechungsfrei aus einer Bahn bzw. Stapel HTSL ausgeführt ist. Die in Fig. 2 gezeigten Knotenpunkte, z.B. von Strompfad B mit Strompfad A1 dienen nur der Erläuterung und sind in der Ausführung zu vermeiden.

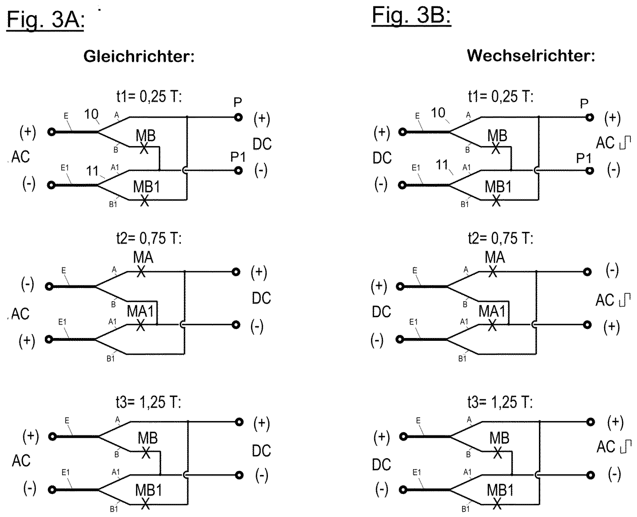

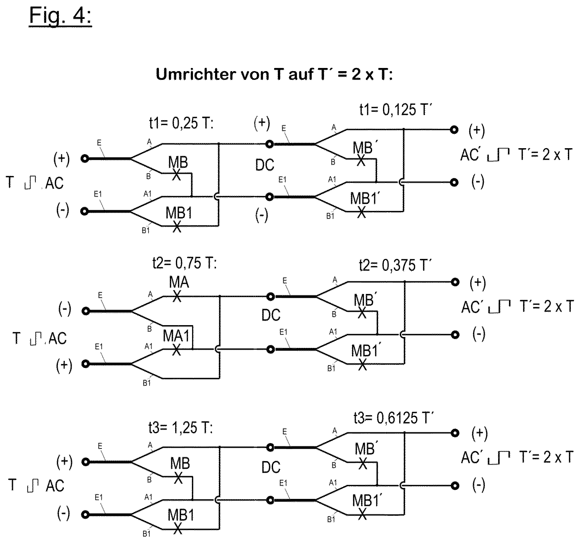

**Fig. 3A, 3B** **und** **4** erläutern den Betrieb der erfindungsgemäßen zweipoligen Schaltvorrichtungen aus Fig. 2 als unterschiedliche Stromrichter. Die schaltbaren Magnete und die Steuerung sind nicht dargestellt, aber vorhanden und es sind nur die im dargestellten Zeitpunkt jeweils geschalteten Magnetpaare, z.B. MB, MB1, gekennzeichnet zusammen mit einem "X", welches den durch die geschalteten Magnetpaare hochohmig gemachten und somit gesperrten Strompfade kennzeichnet.

**Fig. 3A** zeigt den Betrieb eines erfindungsgemäßen Gleichrichters am Beispiel einer eingangsseitigen an den Stromverbindungen E,E1 anliegenden Wechselspannung AC mit der Periode T bzw. Frequenz 1/T. Die freien Enden der paarweise gekreuzt zusammengeführten alternativen Strompfade A,B1 bzw. B,A1 bilden dabei die beiden Ausgangspole P bzw. P1

Zum Zeitpunkt t1 = 0,25 T liegt eingangsseitig die positive Halbwelle der Wechselspannung AC an. Die Stromzuführung E der ersten oben liegend dargestellten Schaltvorrichtung liegt daher an positiver Spannung. Da der erste Strompfad A der ersten Schaltvorrichtung offen ist und der zweite Strompfad B der ersten Schaltvorrichtung durch den geschalteten Magneten MB geschlossen ist, liegt ausgangsseitig am freien Ende des ersten Strompfads A, welche in den oberen Ausgangspol P mündet, daher ebenfalls positive Spannung an. Analog gilt für die Stromverbindung E1 der zweiten unten liegend dargestellten Schaltvorrichtung: An E1 liegt negative Spannung an. Da der erste Strompfad A1 der zweiten Schaltvorrichtung offen ist und der zweite Strompfad B1 der zweiten Schaltvorrichtung durch den geschalteten Magneten MB1 geschlossen ist, liegt ausgangsseitig am freien Ende des ersten Strompfads A1, welcher in den unteren Ausgangspol P1 mündet, daher ebenfalls negative Spannung an.

Zum Zeitpunkt t2 = 0,75 T liegt eingangsseitig die negative Halbwelle der Wechselspannung AC an. Die Stromverbindung E der ersten oben liegend dargestellten Schaltvorrichtung liegt daher an negativer Spannung. Da der erste Strompfad A der ersten Schaltvorrichtung durch den geschalteten Magneten MA geschlossen ist und der zweite Strompfad B der ersten Schaltvorrichtung offen ist, liegt ausgangsseitig am freien Ende des zweiten Strompfads B, welcher in den unteren Ausgangspol P1 mündet, daher ebenfalls negative Spannung an. Analog gilt für die Stromverbindung E1 der zweiten unten liegend dargestellten Schaltvorrichtung: An E1 liegt nun positive Spannung an. Da der erste Strompfad A1 der zweiten Schaltvorrichtung durch den geschalteten Magneten MA1 geschlossen ist und der zweite Strompfad B1 der zweiten Schaltvorrichtung offen ist, liegt ausgangsseitig am freien Ende des zweiten Strompfads B1, welcher in den oberen Ausgangspol P mündet, daher ebenfalls positive Spannung an.

Zum Zeitpunkt t3 = 1,25 T liegt eingangsseitig wieder die positive Halbwelle der Wechselspannung AC an, so dass der gleiche Zustand wie zum bereits beschriebenen Zeitpunkt t1 = 0,25 T.

Es ist erkennbar, dass durch das Schalten der Magnete und die gekreuzten verbundenen alternativen Strompfade stets am oberen Pol P eine positive Spannung und am unteren Pol P eine negative Spannung anliegt. Eine ggf. notwendige Glättung der ausgangsseitigen Gleichspannung kann der Fachmann vorsehen.

In Fig. 3A wurde der Kommutierungsvorgang zum Zeitpunkt t = n x T/2 (Nulldurchgang der Wechselspannung) nicht dargestellt.

**Fig. 3B** zeigt analog zu Fig. 3A den Betrieb eines erfindungsgemäßen Wechselrichters am Beispiel einer eingangsseitigen an den Stromverbindungen E, E1 anliegenden Gleichspannung DC, welche in eine Wechselspannung AC mit der Periode T bzw. Frequenz 1/T umgerichtet wird. Die freien Enden der paarweise gekreuzt zusammengeführten alternativen Strompfade A,B1 bzw. B,A1 bilden dabei die beiden Ausgangspole P bzw. P1

Permanent, also auch zum Zeitpunkt t1 = 0,25 T, liegt eingangsseitig eine Gleichspannung DC an. Zu diesem Zeitpunkt t1 soll der Wechselrichter eine positive Spannung an den ersten Ausgangspol P und eine negative Spannung an den zweiten Ausgangspol P1 legen. Die Stromverbindung E der ersten oben liegend dargestellten Schaltvorrichtung liegt daher an positiver Spannung und die Stromverbindung E1 der zweiten unten liegend dargestellten Schaltvorrichtung liegt an negativer Spannung. Da der erste Strompfad A der ersten Schaltvorrichtung offen ist und der zweite Strompfad B der ersten Schaltvorrichtung durch den geschalteten Magneten MB geschlossen ist, liegt ausgangsseitig am freien Ende des ersten Strompfads A, welche in den oberen Ausgangspol P mündet, daher ebenfalls positive Spannung an. Analog gilt für die Stromverbindung E1 der zweiten unten liegend dargestellten Schaltvorrichtung: An E1 liegt negative Spannung an. Da der erste Strompfad A1 der zweiten Schaltvorrichtung offen ist und der zweite Strompfad B1 der zweiten Schaltvorrichtung durch den geschalteten Magneten MB1 geschlossen ist, liegt ausgangsseitig am freien Ende des ersten Strompfads A1, welcher in den unteren Ausgangspol P1 mündet, daher ebenfalls negative Spannung an.

Zum Zeitpunkt t2 = 0,75 T legt der Wechselrichter eine negative Spannung an den ersten Ausgangspol P und eine positive Spannung an den zweiten Ausgangspol P1. Somit liegt gegenüber dem vorherigen Zeitpunkt t1 eine Polumkehrung vor. Die Stromverbindung E der ersten oben liegend dargestellten Schaltvorrichtung liegt unverändert an positiver Spannung und die Stromverbindung E1 der zweiten unten liegend dargestellten Schaltvorrichtung liegt an negativer Spannung. Da der zweite Strompfad B der ersten Schaltvorrichtung offen ist und der erste Strompfad A der ersten Schaltvorrichtung durch den geschalteten Magneten MA geschlossen ist, liegt ausgangsseitig am freien Ende des zweiten Strompfads B, welcher in den unteren Ausgangspol P1 mündet, daher ebenfalls positive Spannung an. Analog gilt für die Stromverbindung E1 der zweiten unten liegend dargestellten Schaltvorrichtung: An E1 liegt negative Spannung an. Da der zweite Strompfad B1 der zweiten Schaltvorrichtung offen ist und der erste Strompfad A1 der zweiten Schaltvorrichtung durch den geschalteten Magneten MA1 geschlossen ist, liegt ausgangsseitig am freien Ende des zweiten Strompfads B1, welcher in dem oberen Ausgangspol P mündet, daher ebenfalls negative Spannung an.

Zum Zeitpunkt t3 = 1,25 T, also eine Periode nach t1 liegt wieder der gleiche Zustand vor wie zum bereits beschriebenen Zeitpunkt t1 = 0,25 T.

Es ist erkennbar, dass durch das Schalten der Magnete und die gekreuzten verbundenen alternativen Strompfade die positive Spannung abwechselnd am oberen Pol P und unteren Pol P1 anliegt. Das Beispiel erzeugt eine Rechteck-Wechselspannung an den Polen P, P1 mit der Periode T. Andere Spannungsverläufe der Wechselspannung, z.B. Sinus-Welle, Modulation oder Pulsweitenmodulation, kann der Fachmann vorsehen.

In Fig. 3A wurde der Kommutierungsvorgang zum Zeitpunkt t = n x T/2 (Polwechsel) nicht dargestellt.

**Fig. 4** zeigt, dass durch Hintereinanderschalten des Gleichrichters aus Fig. 3A und des Wechselrichters aus Fig. 3B ein Umrichter realisierbar ist. Dargestellt ist die Umrichtung einer eingangsseitig anliegenden Rechteckwechselspannung mit der Periode T in eine ausgangsseitig an den Polen P, P1 bereitgestellte Rechteckwechselspannung mit der doppelten Periode T'= 2 T. Zum Betrieb des links dargestellten Gleichrichters gilt das zu Fig. 3A gesagte. Dieser stellt somit eine Gleichspannung DC für den nachgeschalteten rechts dargestellten Wechselrichter bereit, welche ggf. durch die üblichen Maßnahmen auch geglättet sein kann, z.B. im Fall von einer eingangsseitigen Sinus-Wechselspannung.

Der hier dargestellte Wechselrichter wird betrieben wie zu Fig. 3B erläutert, mit der Ausnahme, dass dieser eine Wechselspannung mit der Periode T' = 2 T erzeugt, also und daher zum Zeitpunkt t2 = 0,75 t = 0,0375 T' nur noch keinen Polwechsel durchführt. Dieser erfolgt erst bei T =0,5 T'.

Die Magnete MA, MA1, MB, MB2 des Gleichrichters und MA', MA1', MB', MB2' des Wechselrichters sind vorzugsweise an eine gemeinsame Steuerung angeschlossen, was hier nicht dargestellt ist.

## Patentansprüche

1. Hochtemperatur supraleitende Schaltvorrichtung (10), insbesondere für Umrichter-, Gleichrichter- oder Wechselrichter-Schaltungen, mit mindestens einer Stromverbindung (E), welche sich zu mindestens zwei unabhängig voneinander schaltbaren alternativen Strompfaden (A, B) verzweigt, wobei die Stromverbindung und die Strompfade durchgängig hochtemperatur supraleitende Leiter abgekürzt "HTSL" aufweisen und die HTSL ausgelegt sind zum Leiten eines Transportstroms, mit einer Kühlvorrichtung zum Kühlen der HTSL unterhalb von deren Sprungtemperatur, wobei jedem Strompfad (A,B) ein schaltbarer Magnet (MA, MB) räumlich zugeordnet ist; die Magnete (MA, MB) mit einer Steuerung (S) mit einer Wechselstromquelle zum Erzeugen eines Wechsel-Magnetfeldes verbunden sind;
jeder schaltbare Magnet (MA) so zu dem ihm zugeordneten Strompfad (A) angeordnet ist und durch die Steuerung so angesteuert werden kann, dass er durch Erzeugen eines Wechsel-Magnetfeldes im HTSL des zugeordneten Strompfads (A) einen dynamischen Widerstand erzeugen kann, der den Strompfad hochohmig macht, wobei
jeder schaltbare Magnet (MA) so zu dem ihm nicht zugeordneten Strompfad (B) angeordnet ist und durch die Steuerung so angesteuert werden kann, dass er durch Erzeugen eines Wechsel-Magnetfeldes im HTSL des **nicht** zugeordneten Strompfads (B) keinen dynamischen Widerstand erzeugen kann, so dass der nicht-zugeordnete Strompfad supraleitend bleibt
**dadurch gekennzeichnet, dass**
die Stromverbindung (E) und alle alternativen Strompfade (A, B) einstückig aus HTSL Bändern bestehen, sodass diese keine Fügezonen mit Übergangswiderstand aufweisen, wobei
die HTSL-Bänder zumindest im Wirkungsbereich der dem jeweiligen Strompfad zugeordneten schaltbaren Magneten senkrecht zur ihrer Bandebene entlang ihrer Längsachse geschnitten sind zur Ausbildung von alternativen Strompfaden.

2. Schaltvorrichtung nach Anspruch 1, **dadurch gekennzeichnet, dass** die Steuerung die schaltbaren Magnete so ansteuert, dass wenn der eine Strompfad supraleitend ist und der andere Strompfad hochohmig ist und ein Schaltvorgang stattfinden soll, bei welchem der eine Strompfad hochohmig wird ist und der andere Strompfad supraleitend wird, die Steuerung für eine definierte Zeit im Schaltvorgang beide Strompfade supraleitend hält.

3. Schaltvorrichtung nach einem der vorherigen Ansprüche, **dadurch gekennzeichnet, dass** die HTSL als HTSL Bänder ausgebildet sind;
und/oder
die Stromverbindung (E) den gleichen stromführenden Querschnitt aus HTSL wie die alternativen Strompfade (A, B) zusammen hat, wobei vorzugsweise jeder der alternativen Strompfade den gleichen stromführenden Querschnitt aus HTSL hat.

4. **Gleichrichter** mit einer Schaltvorrichtung (10) nach einem der vorherigen Ansprüche 1-3, **dadurch gekennzeichnet, dass** bei Anschluss der Stromverbindung an eine Wechselspannung die Steuerung
den einen Strompfad nur solange ansteuert und somit hochohmig macht, wie die Wechselspannung positive Spannungen durchläuft; und
den andere Strompfad nur solange ansteuert und somit hochohmig macht, wie die Wechselspannung negative Spannungen durchläuft.

5. Gleichrichter nach Anspruch 4, **dadurch gekennzeichnet, dass** die Steuerung im Zeitraum eines Nulldurchgangs der Wechselspannung beide Strompfade nicht ansteuert und somit supraleitend macht,
wobei vorzugsweise als Zeitraum des Nulldurchgangs gilt:
eine Zeit von 1/1.000 der Periode des Wechselstroms vor und nach dem Nulldurchgang; oder
eine Zeit während der der Absolutwert der Wechselspannung kleiner als 0,6% der Dachspannung des Wechselstroms ist.

6. **Wechselrichter** mit einer Schaltvorrichtung (10) nach einem der vorherigen Ansprüche 1-3, **dadurch gekennzeichnet, dass** bei Anschluss der Stromverbindung an eine Gleichspannung die Steuerung mit einer Frequenz wechselweise den einen Strompfad oder den anderen Strompfad ansteuert und hochohmig macht.

7. Wechselrichter nach Anspruch 6, **dadurch gekennzeichnet, dass** die Steuerung während des Wechsels von einem Strompfad zum anderen Strompfad beide Strompfade für einen Zeitraum nicht ansteuert und somit nicht hochohmig macht, sodass für diesen Zeitraum beide Strompfade supraleitend sind.

8. Wechselrichter nach Anspruch 6 oder 7, **dadurch gekennzeichnet, dass** der Zeitraum definiert ist als 1/1.000 der Periode der Frequenz des Wechselns der Strompfade.

9. **Gleichrichter bzw. Wechselrichter** nach einem der vorherigen Ansprüche -4-5 bzw. -6-8 , **dadurch gekennzeichnet, dass** dieser eine zweite Schaltvorrichtung (11) nach einem der vorherigen Ansprüche 1-5 aufweist, wobei die Stromverbindung (E) der ersten Schaltvorrichtung (10) und die Stromverbindung (E1) der zweiten Schaltvorrichtung (11) zwei Eingangspole des Gleichrichter bzw. Wechselrichter bilden und
die zwei unabhängig voneinander schaltbaren alternativen Strompfade (A, B) der ersten Schaltvorrichtung (10) und die zwei unabhängig voneinander schaltbaren alternativen Strompfade (A1, B1) der zweiten Schaltvorrichtung (11) über Kreuz miteinander supraleitend verbunden sind zur Bildung von zwei Ausgangspolen des Gleichrichter bzw. Wechselrichters,
wobei die ersten Magnete (MA,MB) der ersten Schaltvorrichtung und die zweiten Magnete (MA1,MB1) der zweiten Schaltvorrichtung mit einer gemeinsamen Steuerung (S) verbunden sind und von dieser gleichsinnig angesteuert werden.

10. Gleichrichter bzw. Wechselrichter nach Anspruch 9, **dadurch gekennzeichnet, dass** die gleichsinnig angesteuerten Magnete (MA, MA1 bzw. MB, MB1) jeweils elektrisch in Reihe geschaltet und mit der gemeinsamen Steuerung (S) verbunden sind.

11. Gleichrichter bzw. Wechselrichter nach Anspruch 9, **dadurch gekennzeichnet, dass** die gleichsinnig angesteuerten Magnete (MA, MA1 bzw. MB, MB1) jeweils als ein gemeinsamer Magnet ausgebildet sind, und
jeder gemeinsame Magnet so zu den ihm zugeordneten Strompfaden (A, A1 bzw. B, B1) angeordnet ist und durch die Steuerung so angesteuert werden kann, dass er durch Erzeugen eines Wechsel-Magnetfeldes im HTSL der zugeordneten Strompfade (A, A1 bzw. B, B1) einen dynamischen Widerstand erzeugen kann, der die Strompfade hochohmig macht, wobei
jeder gemeinsame Magnet so zu den ihm nicht zugeordneten Strompfaden (A, A1 bzw. B, B1) angeordnet ist und durch die Steuerung so angesteuert werden kann, dass er durch Erzeugen eines Wechsel-Magnetfeldes im HTSL der nicht zugeordneten Strompfade (A, A1 bzw. B, B1) keinen dynamischen Widerstand erzeugen kann, so dass der nicht-zugeordnete Strompfad supraleitend bleibt.

12. **Umrichter** mit einem Gleichrichter nach einem der vorherigen Ansprüche und einem dahinter geschalteten Wechselrichter nach einem der vorherigen Ansprüche, wobei mindestens ein freies Ende einer der Strompfade des Gleichrichters mit dem Stromeingang des Wechselrichters leitend verbunden ist.

13. Verfahren zum Betreiben der Schaltvorrichtung oder des Gleichrichters oder des Wechselrichters oder des Umrichters nach einem der vorherigen Ansprüche,
wobei die Steuerung mit ihrer Wechselstromquelle die Ansteuerung des schaltbaren Magneten (MA) durch Erzeugen eines Wechsel-Magnetfeldes durchführt,
wobei im HTSL des dem Magneten zugeordneten Strompfads (A) durch das Wechsel-Magnetfeld ein dynamischer Widerstand erzeugt wird, der den Strompfad hochohmig macht,
wobei vorzugsweise die Amplitude oder der Effektivwert des Wechsel-Magnetfeldes kleiner ist als die kritische magnetische statische Feldstärke, welche nötig wäre, um den Strompfad im gleichen Fall hochohmig zu machen, insbesondere vorzugsweise um ein Vielfaches kleiner,
wobei ferner vorzugsweise die Frequenz des Wechsel-Magnetfelds 40 - 4.000 Hz, vorzugsweise 200 - 2.000 Hz und insbesondere vorzugsweise 400 - 1.200 Hz beträgt.

## Claims

1. A high-temperature superconducting switching device (10), in particular for converter, rectifier or inverter circuits, comprising at least one current connection (E) which branches into at least two independently switchable alternative current paths (A, B), wherein the current connection and the current paths have continuous high-temperature superconducting conductors, abbreviated "HTSL", and the HTSL are adapted for conducting a transport current, comprising a cooling device for cooling the HTSL below their transition temperature, wherein
a switchable magnet (MA, MB) is spatially assigned to each current path (A, B);
the magnets (MA, MB) are connected to a controller (S) having an alternating current source for generating an alternating magnetic field;
each switchable magnet (MA) is arranged relative to the current path (A) assigned to it and is able to be controlled by the controller such that it can generate a dynamic resistance by generating an alternating magnetic field in the HTSL of the assigned current path (A), which makes the current path high-impedance, wherein
each switchable magnet (MA) is arranged relative to the current path (B) not assigned to it and is able to be controlled by the controller such that it cannot generate any dynamic resistance by generating an alternating magnetic field in the HTSL of the current path (B) not assigned to it, so that the non-assigned current path remains superconducting
**characterised in that**
the current connection (E) and all alternative current paths (A, B) consist of HTSL tapes in one piece, so that these have no joining zones with transition resistance, wherein
the HTSL tapes are cut perpendicular to their tape plane along their longitudinal axis at least in the effective range of the switchable magnets assigned to the respective current path for forming alternative current paths.

2. The switching device according to claim 1, **characterised in that** the controller controls the switchable magnets such that when one current path is superconducting and the other current path is high-impedance and a switching operation is to take place in which the one current path becomes high-impedance and the other current path becomes superconducting, the controller keeps both current paths superconducting for a defined time during the switching operation.

3. The switching device according to one of the preceding claims, **characterised in that** the HTSL are formed as HTSL tapes;
and/or
the current connection (E) has the same current-carrying cross-section of HTSL as the alternative current paths (A, B) together, wherein preferably each of the alternative current paths has the same current-carrying cross-section of HTSL.

4. A rectifier comprising a switching device (10) according to one of the preceding claims 1-3, **characterised in that** when the current connection is connected to an alternating voltage, the controller
controls the one current path and thus makes it high-impedance only as long as the alternating voltage passes through positive voltages; and
controls the other current path and thus makes it high-impedance only as long as the alternating voltage passes through negative voltages.

5. The rectifier according to claim 4, **characterised in that** the controller does not control any of the two current paths during the period of a zero crossing of the alternating voltage, thus making them superconducting,
wherein preferably the period of the zero crossing is defined as:
a time of 1/1,000 of the period of the alternating current before and after the zero crossing; or
a time during which the absolute value of the alternating voltage is less than 0.6% of the peak voltage of the alternating current.

6. An inverter comprising a switching device (10) according to one of the preceding claims 1-3, **characterised in that** when the current connection is connected to a direct voltage, the controller alternately controls the one current path or the other current path at a frequency, making it high-impedance.

7. The inverter according to claim 6, **characterised in that** the controller does not control any of the two current paths for a period during the change from one current path to the other current path and thus does not make them high-impedance, so that both current paths are superconducting for this period.

8. The inverter according to claim 6 or 7, **characterised in that** the period is defined as 1/1,000 of the period of the frequency of the changing of the current paths.

9. The rectifier and/or inverter according to one of the preceding claims 4-5 or 6-8, respectively, **characterised in that** it comprises a second switching device (11) according to one of the preceding claims 1-5, wherein the current connection (E) of the first switching device (10) and the current connection (E1) of the second switching device (11) form two input poles of the rectifier and/or inverter and
the two independently switchable alternative current paths (A, B) of the first switching device (10) and the two independently switchable alternative current paths (A1, B1) of the second switching device (11) are superconductively connected to one another in a crosswise manner to form two output poles of the rectifier and/or inverter,
wherein the first magnets (MA, MB) of the first switching device and the second magnets (MA1, MB1) of the second switching device are connected to a common controller (S) and are controlled by it in the same sense.

10. The rectifier and/or inverter according to claim 9, **characterised in that** the magnets (MA, MA1 or MB, MB1, respectively) controlled in the same sense are each electrically connected in series and connected to the common controller (S).

11. The rectifier and/or inverter according to claim 9, **characterised in that** the magnets (MA, MA1 or MB, MB1, respectively) controlled in the same sense are each formed as a common magnet, and
each common magnet is arranged relative to the current paths (A, A1 or B, B1, respectively) assigned to it and can be controlled by the controller such that it can generate a dynamic resistance by generating an alternating magnetic field in the HTSL of the assigned current paths (A, A1 or B, B1, respectively), which makes the current paths high-impedance, wherein
each common magnet is arranged relative to the current paths (A, A1 or B, B1, respectively) not assigned to it and is able to be controlled by the controller such that it cannot generate any dynamic resistance by generating an alternating magnetic field in the HTSL of the current paths (A, A1 or B, B1, respectively) not assigned to it, so that the non-assigned current path remains superconducting.

12. A converter comprising a rectifier according to one of the preceding claims and an inverter according to one of the preceding claims connected downstream thereof, wherein at least one free end of one of the current paths of the rectifier is conductively connected to the current input of the inverter.

13. A method for operating the switching device or the rectifier or the inverter or the converter according to one of the preceding claims,
wherein the controller with its alternating current source performs the control of the switchable magnet (MA) by generating an alternating magnetic field,
wherein a dynamic resistance is generated in the HTSL of the current path (A) assigned to the magnet by the alternating magnetic field, which makes the current path high-impedance,
wherein preferably the amplitude or the effective value of the alternating magnetic field is smaller than the critical magnetic static field strength which would be necessary to make the current path high-impedance in the same case, in particular preferably smaller by a multiple,
wherein furthermore preferably the frequency of the alternating magnetic field is 40 - 4,000 Hz, preferably 200 - 2,000 Hz and particularly preferably 400 - 1,200 Hz.

## Revendications

1. Dispositif de commutation supraconducteur à haute température (10), en particulier pour les circuits convertisseurs, redresseurs ou onduleurs, avec au moins une connexion de courant (E), qui se ramifie vers au moins deux chemins alternatifs de courant commutables indépendamment (A, B), dans lequel la connexion de courant et les chemins de courant présentent, sans interruption, des conducteurs supraconducteurs à haute température, abrégés « HTSL », et les HTSL sont conçus pour conduire un courant de transport, avec un dispositif de refroidissement pour un refroidissement des HTSL en dessous de leur température de transition, dans lequel un aimant commutable (MA, MB) est spatialement assigné à chaque chemin de courant (A, B) ;
les aimants (MA, MB) sont connectés à une commande (S) avec une source de courant alternatif pour générer un champ magnétique alternatif ;
chaque aimant commutable (MA) est disposé en sorte par rapport au chemin de courant (A) qui lui est assigné et peut être commandé en sorte par la commande qu'il peut générer **une** résistance dynamique en générant un champ magnétique alternatif dans le HTSL du chemin de courant (A) assigné, qui rend le chemin de courant à haute impédance, dans lequel
chaque aimant commutable (MA) est disposé en sorte par rapport au chemin de courant (B) qui n'est **pas** assigné à lui et peut être commandé en sorte par la commande qu'il ne peut **pas** générer de résistance dynamique en générant un champ magnétique alternatif dans le HTSL du chemin de courant non attribué (B), de sorte que le chemin de courant non assigné reste supraconducteur **caractérisé en ce que**
la connexion de courant (E) et tous les chemins alternatifs de courant (A, B) sont constitués de bandes HTSL en une seule pièce, de sorte qu'ils n'ont pas de zones de jonction avec résistance de contact, dans lequel
les bandes HTSL sont coupées, au moins dans la zone d'action des aimants commutables assignés au chemin de courant respectif, de manière perpendiculaire à leur plan de bande le long de leur axe longitudinal, pour former des chemins alternatifs de courant.

2. Dispositif de commutation selon la revendication 1, **caractérisé en ce que** la commande commande les aimants commutables de telle sorte que, si l'un chemin de courant est supraconducteur et l'autre chemin de courant est à haute impédance et qu'un processus de commutation doit avoir lieu dans lequel l'un chemin de courant devient est à haute impédance et l'autre chemin de courant devient supraconducteur, la commande garde les deux chemins de courant supraconducteurs pendant un temps défini dans le processus de commutation.

3. Dispositif de commutation selon l'une des revendications précédentes, **caractérisé en ce que** les HTSL sont formés en bandes HTSL ;
et/ou
la connexion de courant (E) a la même section efficace portant le courant de HTSL que les chemins alternatifs de courant (A, B) ensemble, dans lequel de préférence chacun des chemins alternatifs de courant a la même section efficace portant le courant de HTSL.

4. **Redresseur** avec un dispositif de commutation (10) selon l'une des revendications précédentes 1 à 3, **caractérisé en ce que**, lorsque la connexion de courant est connectée à une tension alternative, la commande
ne commande l'un chemin de courant et le rend donc à haute impédance que tant que la tension alternative passe à travers des tensions positives ; et
ne commande l'autre chemin de courant et le rend donc à haute impédance que tant que la tension alternative passe à travers des tensions négatives.

5. Redresseur selon la revendication 4, **caractérisé en ce que** la commande ne commande pas les deux chemins de courant dans la période de temps d'un passage à zéro de la tension alternative et les rend ainsi supraconducteurs,
dans lequel de préférence la période de temps du passage à zéro est considérée comme :
un temps de 1/1 000 de la période du courant alternatif avant et après le passage à zéro ; ou
un temps pendant laquelle la valeur absolue du courant alternatif est inférieure à 0,6 % de la tension de crête du courant alternatif.

6. **Onduleur** avec un dispositif de commutation (10) selon l'une des revendications 1 à 3 précédentes, **caractérisé en ce que**, lorsque la connexion de courant est connectée à une tension continue, la commande, à une certaine fréquence, commande alternativement l'un chemin de courant ou l'autre chemin de courant et le rend à haute impédance.

7. Onduleur selon la revendication 6, **caractérisé en ce que**, lors du passage d'un chemin de courant à l'autre chemin de courant, la commande ne commande pas les deux chemins de courant pendant une période de temps et ne les rend donc pas à haute impédance, de sorte que les deux chemins de courant sont supraconducteurs pendant cette période de temps.

8. Onduleur selon la revendication 6 ou 7, **caractérisé en ce que** la période de temps est définie comme 1/1 000 de la période de la fréquence du changement des chemins de courant.

9. **Redresseur, respectivement onduleur,** selon l'une des revendications précédentes -4-5 respectivement -6-8, **caractérisé en ce que** celui présente un deuxième dispositif de commutation (11) selon l'une des revendications 1-5, dans lequel la connexion de courant (E) du premier dispositif de commutation (10) et la connexion de courant (E1) du deuxième dispositif de commutation (11) forment deux pôles d'entrée du redresseur, respectivement de l'onduleur, et
les deux chemins alternatifs (A, B) commutables indépendamment du premier dispositif de commutation (10) et les deux chemins alternatifs (A1, B1) commutables indépendamment du deuxième dispositif de commutation (11) sont connectés entre eux de manière supraconductrice en croix pour former deux pôles de sortie du redresseur, respectivement de l'onduleur,
dans lequel les premiers aimants (MA, MB) du premier dispositif de commutation et les deuxièmes aimants (MA1, MB1) du deuxième dispositif de commutation sont connectés à une commande commune (S) et sont commandés par celle-ci dans le même sens.

10. Redresseur, respectivement onduleur, selon la revendication 9, **caractérisé en ce que** les aimants commandés dans le même sens (MA, MA1, respectivement MB, MB1) sont chacun connectés électriquement en série et connectés à la commande commune (S).

11. Redresseur, respectivement onduleur, selon la revendication 9, **caractérisé en ce que** les aimants commandés dans le même sens (MA, MA1, respectivement MB, MB1) sont chacun formés comme un aimant commun, et
chaque aimant commun est disposé en sorte par rapport aux chemins de courant qui lui sont assignés (A, A1, respectivement B, B1) et peut être commandé par la commande en sorte qu'il peut générer une résistance dynamique en générant un champ magnétique alternatif dans le HTSL des chemins de courant assignés (A, A1, respectivement B, B1), qui rend les chemins de courant à haute impédance, dans lequel
chaque aimant commun est disposé en sorte par rapport aux chemins de courant qui ne sont pas assignés à lui (A, A1, respectivement B, B1) et peut être commandé en sorte par la commande qu'il ne peut pas générer de résistance dynamique en générant un champ magnétique alternatif dans le HTSL des chemins de courant non assignés (A, A1, respectivement B, B1), de sorte que le chemin de courant non assigné reste supraconducteur.

12. **Convertisseur** avec un redresseur selon l'une des revendications précédentes et un onduleur connecté en aval selon l'une des revendications précédentes, dans lequel au moins une extrémité libre de l'un des chemins de courant du redresseur est connectée de manière conductrice à l'entrée de courant de l'onduleur.

13. **Procédé** de fonctionnement du dispositif de commutation, du redresseur, de l'onduleur ou du convertisseur selon l'une des revendications précédentes,
dans lequel la commande avec sa source de courant alternatif effectue la commande de l'aimant commutable (MA) en générant un champ magnétique alternatif,
dans lequel, dans le HTSL du chemin de courant (A) assigné à l'aimant, une résistance dynamique est générée par le champ magnétique alternatif, qui rend le chemin de courant à haute impédance,
dans lequel de préférence l'amplitude ou la valeur efficace du champ magnétique alternatif est inférieure à l'intensité de champ statique magnétique critique, qui serait nécessaire pour rendre le chemin de courant à haute impédance dans le même cas, en particulier, de préférence, inférieure d'un multiple,
dans lequel la fréquence du champ magnétique alternatif est en outre de préférence 40 - 4 000 Hz, de préférence 200 - 2 000 Hz et en particulier de préférence 400 - 1 200 Hz.
